# EUROPÄISCHE PATENTANMELDUNG

(11) **EP 1 128 420 A2**
(43) Veröffentlichungstag der Anmeldung: **29.08.2001**
(21) Anmeldenummer: 01103453.5
(22) Anmeldetag: 14.02.2001
(51) Int. Cl.: H01L 21/314

(54) **Verfahren zum Auffüllen von Vertiefungen in einer Oberfläche einer Halbleiterstruktur**

(30) Priorität: 25.02.2000 DE 10010286
(71) Anmelder: Infineon Technologies AG, 81669 München (DE)
(72) Erfinder: Kirchhoff, Markus, Dr., 01458 Ottendorf-Okrilla (DE)
(74) Vertreter: Epping Hermann & Fischer

(57) **Zusammenfassung**

Auf einer Halbleiterstruktur wird in Vertiefungen auf der Oberfläche, insbesondere unterhalb der ersten Metallstrukturebene, eine Diffusionsbarriereschicht, vorzugsweise mit Hilfe einer plasmaunterstützten Gasphasenabscheidung, bei der die im Plasma enthaltenen Ionen senkrecht zur Oberfläche beschleunigt werden, abgeschieden, so dass sich eine nicht konforme Abscheidung der Diffusionsbarriereschicht ergibt.

## Beschreibung

Die Erfindung betrifft ein Verfahren zum Auffüllen von Vertiefungen in einer Oberfläche einer Halbleiterstruktur und eine auf diese Weise aufgefüllte Halbleiterstruktur.

Halbleiterstrukturen, wenn sie als integrierte Schaltungen genutzt werden, entstehen durch lagegenau übereinander angeordnete Schichten, die strukturiert sind. Da die Strukturen in diesen Schichten eine Dicke im Bereich von 0,1 µm bis 1 µm aufweisen, ist es erforderlich, die Oberfläche zu planarisieren bevor eine neue Struktur ausgebildet wird, um steile Stufen zur Schichtaufbringung zu vermeiden. Solche steilen Stufen sind insbesondere dann nachteilhaft, wenn eine Metalllage zur Verdrahtung der Schaltungselemente in der Halbleiterstruktur abgeschieden werden soll. An einer stufenbehafteten Oberfläche ist aufgrund der begrenzten Konformität der zur Metallaufbringung verwendeten Sputterbeschichtung die Dicke der Metallisierung an steilen Kanten oft sehr niedrig. Hierdurch werden die Leiterbahnquerschnitte deutlich geringer als auf einer planaren Oberfläche. In solchen verengten Leiterbahnbereichen steigt dann die Stromstärke stark an, was zu einem schnellen Altern der Leiterbahnen führen kann. Darüber hinaus besteht auch die Gefahr, dass, wenn die Leiterbahn über eine Stufe läuft, aufgrund einer unvollständigen Bedeckung der Stufe, ein Kantenabriss auftritt.

Zur Planarisierung der Halbleiterstrukturen vor der Ausführung der ersten Metallisierungsebene wird im Allgemeinen die Reflow-Technik von dotierten Silikat-Gläsern eingesetzt. Die Silikat-Gläser werden dabei vor allem mit Phosphor (PSG) oder mit Bor und Phosphor (BPSG) dotiert. Bei hohen Temperaturen beginnen diese Gläser zu verfließen, wodurch sich auch schmale Vertiefungen in der Halbleiteroberfläche ausfüllen lassen. Ein derartiges Verfahren ist z. B. in der US 5,858,848 beschrieben.

Die dotierten Silikat-Glasschichten werden im Allgemeinen mit einer Gasphasenabscheidung, einer sog. CVD-Abscheidung, auf der Oberfläche hergestellt. Bei der CVD-Abscheidung erfolgt eine thermische Zersetzung von chemischen Verbindungen, die in der Summe sämtliche Komponenten der zu erzeugenden dotierten Silikat-Glasschicht enthalten. Je nach Druck- und Energiezufuhr werden dabei die CVD-Verfahren in Atmosphären-, Niederdruck- und Plasma-CVD-Abscheidung eingeteilt. Nach der Aufbringung der dotierten Silikat-Glasschicht wird diese dann einem Hochtemperaturschritt unterworfen, wobei die erforderliche Temperatur wesentlich vom Phosphorgehalt abhängt. Bei einer Temperaturbehandlung von BPSG mit einem Bor- und Phosphorgehalt von jeweils ca. 4 % bei 800 bis 850°C über 20 bis 30 min lassen sich Vertiefungen bis zu einer Breite von 0,15 µm und einem Tiefen-Breiten-Verhältnis von 5:1 hohlraumfrei ausfüllen.

Um zu verhindern, dass die Dotieratome aus dem Silikat-Glas, insbesondere während des Hochtemperaturschrittes, in die darunterliegende Halbleiterschicht diffundieren, wird vor der Abscheidung der dotierten Silikat-Glasschicht eine Diffusionsbarrierenschicht auf der Oberfläche der Halbleiterstruktur erzeugt. Wegen seiner hervorragenden Barrierenwirkung wird im Allgemeinen Siliziumnitrid als Zwischenschicht verwendet. Das Siliziumnitrid wird dabei ähnlich dem dotierten Silikat-Glas in CVD-Reaktoren abgeschieden. Als CVD-Prozess zur Siliziumnitrid-Erzeugung werden dabei vorzugsweise das LPCVD-Verfahren ("Low Pressure"-CVD-Verfahren) und das plasmaunterstützte CVD-Verfahren (PECVD) eingesetzt. Bei dem LPCVD-Verfahren erfolgt die Siliziumnitrid-Abscheidung mit SiH₂Cl₂ als Siliziumquelle, wobei eine Prozesstemperatur von 700 bis 800°C auf der Halbleiteroberfläche und ein Druck von 20 bis 40 Pa im Reaktor vorliegen. Die PECVD-Nitrid-Abscheidung nutzt im Gegensatz zum LPCVD-Verfahren SiH₄ als Siliziumquelle, wobei die Prozesstemperatur bei ca. 300 °C liegt. Um das Quellgas beim PECVD-Verfahren zersetzen zu können, wird das Gas zusätzlich mit Hilfe einer Hochfrequenz-Gasentladung angeregt. Der PECVD-Prozess und der LPCVD-Prozess erzeugen dabei eine Siliziumnitrid-Schicht mit einer hohen Konformität, so dass sich auf der gesamten Halbleiteroberfläche eine im Wesentlichen gleich dicke Schicht ergibt.

Durch die Siliziumnitrid-Schicht wird jedoch das Tiefen-Breiten-Verhältnis der Vertiefungen auf der Halbleiteroberfläche, die mit dem dotierten Silikat-Glas hohlraumfrei ausgefüllt werden sollen, vergrößert. Dies führt dazu, dass bei einer weiteren Miniaturisierung der Halbleiterstrukturen mit Breiten unter 0,15 *µ*m das Tiefen-Breiten-Verhältnis weit über dem Grenzwert von 5:1 liegt, bei dem sich mit der bekannten Reflow-Technik von dotierten Silikat-Gläsern hohlraumfrei die Vertiefungen der Halbleiterstrukturen ausfüllen lassen. Es besteht zwar die Möglichkeit, ein verbessertes Zerfließen der dotierten Silikat-Glasschicht durch Einsetzen von Temperaturen von über 800°C beim Aufheizschritt zu erreichen. Bei solchen hohen Temperaturen besteht jedoch die Gefahr, dass sich die elektrischen Parameter der Bauelemente in der Halbleiterstruktur stark verändern bzw. diese zerstört werden.

Aufgabe der vorliegenden Erfindung ist es deshalb, ein verbessertes Auffüllen von Vertiefungen in der Oberfläche einer Halbleiterstruktur, insbesondere unterhalb der ersten Metallebene, zu ermöglichen, mit dem sich auch bei Strukturbreiten von unter 0,15 *µ*m und großen Tiefen-Breiten-Verhältnissen die Vertiefungen hohlraumfrei ausfüllen lassen.

Diese Aufgabe wird durch ein Verfahren mit den Merkmalen des Anspruches 1 und eine Halbleiterstruktur mit den Merkmalen des Anspruches 4 gelöst. Die bevorzugte Weiterbildungen sind in den abhängigen Ansprüchen angegeben.

Das erfindungsgemäße Auffüllen von Vertiefungen auf der Oberfläche einer Halbleiterstruktur, insbesondere unterhalb der ersten Metallebene, erfolgt durch das Erzeugen einer Diffusionsbarriereschicht auf der Halbleiteroberfläche, vorzugsweise mit Hilfe einer plasmaunterstützten Gasphasenabscheidung aus, bei der die im Plasma enthaltenen Ionen zum Aufbau der Diffusionsbarriereschicht senkrecht zur Oberfläche hin beschleunigt werden. Hierdurch wird erreicht, dass die Diffusionsbarriereschicht primär auf den Flächen wächst, die parallel zur Oberfläche verlaufen und weniger auf senkrechten Strukturflächen. Durch die erfindungsgemäße, nicht konforme Abscheidung der Diffusionsbarriereschicht auf der Halbleiteroberfläche wird das Tiefen-Breiten-Verhältnis für die anschließend aufzubringende Planarisierungsschicht verkleinert, so dass sich auch bei Halbleiterstrukturen mit einer Breite unter 0,15 *µ*m zuverlässig Vertiefungen ausfüllen lassen.

Gemäß der Erfindung besteht insbesondere auch die Möglichkeit, das herkömmlicherweise verwendete Siliziumnitrid als Diffusionsbarriere zu nutzen und BPSG als Planarisierungsschicht einzusetzen. Weiterhin kann auch Oxynitrid als Diffusionsbarriere eingesetzt werden. Hierdurch kann die erfindungsgemäße Auffülltechnik leicht in die verschiedenen bekannten Herstellungsverfahren für Halbleiterschaltungen integriert werden.

Gemäß einer weiteren bevorzugten Ausführungsform enthält das Plasma bei der Gasphasenabscheidung zur Erzeugung der Diffusionsbarriereschicht mindestens 1 10¹⁰ Ionen/cm³. Durch diese hohe Plasmadichte kann eine besonders große Nicht-Konformität der Abscheidung der Diffusionsbarriereschicht in den Vertiefungen erreicht werden.

Die Erfindung wird anhand der Zeichnungen näher erläutert. Es zeigen:
- Figur 1: eine Siliziumnitrid-Abscheidung mit einem herkömmlichen LPCVD- oder PECVD-Verfahren,
- Figur 2: eine Siliziumnitrid-Abscheidung mit einem erfindungsgemäßen Verfahren,
- Figur 3: eine mit einem erfindungsgemäßen Verfahren planarisierte Halbleiterstruktur, und
- Figur 4: einen CVD-Reaktor zum Ausführen eines erfindungsgemäßen Verfahrens.

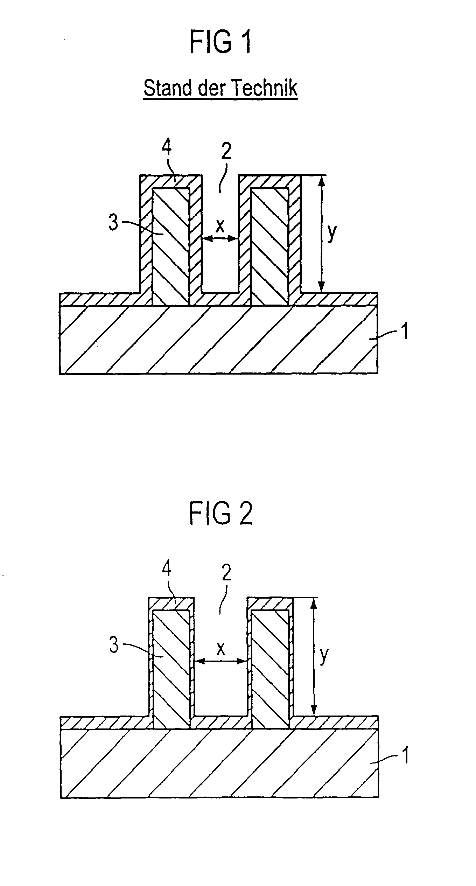

Die erfindungsgemäße Planarisierungstechnik dient zum Auffüllen von Spalten und Gräben auf der Oberfläche einer Halbleiterstruktur, insbesondere unterhalb der ersten Metallebene. Die Figuren 1 bis 3 zeigen einen Querschnitt durch eine solche Halbleiterstruktur. Halbleiterstrukturen werden vor allem als integrierte Schaltungen eingesetzt und können z. B. ein Speicherbaustein oder eine logische Schaltung sein. Als Material für die Halbleiterstruktur wird im Wesentlichen Silizium verwendet. Das Halbleitersubstrat kann jedoch auch ein anderer elementarer Halbleiter, wie z. B. Germanium sowie ein III/V- bzw. ein II/VI-Verbindungshalbleiter sein. Die integrierte Schaltung wird insbesondere mit Hilfe der bekannten Planartechnik in diesem Halbleitersubstrat ausgeführt. Dies beinhaltet eine Abfolge von jeweils ganzflächig über die Halbleiteroberfläche wirkenden Einzelprozesse, die durch geeignete Maskierungsschichten gezielt zur lokalen Veränderung des Halbleitermaterials führen.

Im Allgemeinen werden folgende Bearbeitungsschritte mit der homogen dotierten Halbleiterscheibe ausgeführt. Zuerst wird eine Oxidschicht auf der Halbleiterscheibe erzeugt, dann wird ein lichtempfindlicher Lack aufgetragen und anschließend wird dieser Lack über eine Maske mit einer Struktur einer Entwurfsebene einer integrierten Schaltung belichtet. Dann wird der Lack entwickelt und der belichtete Photolack entfernt. Anschließend wird das Oxid mit dem Photolack als Maskenschicht geätzt. Nach dem Ätzschritt wird der restliche Photolack entfernt und dann eine Diffusion zur lokalen Dotierung der Halbleiterscheibe mit dem Oxid als Maskenschicht ausgeführt. Diese Bearbeitungsfolge wird im Herstellungsprozess mehrfach wiederholt, um die Scheibendotierung lokal unterschiedlich und gezielt zu verändern. Nachdem sämtliche Dotierungen in die Halbleiterscheibe eingebracht sind, endet die Planartechnik mit der Verdrahtung zur Herstellung der elektrischen Verbindungen. Hierzu wird ganzflächig ein Metall zur Erzeugung von Leiterbahnen und Kontaktstellen aufgebracht. Diese Metallebene wird anschließend durch einen durch Photolack maskierten Ätzvorgang strukturiert. Die Planartechnik ermöglicht so die Herstellung von sich stetig auf der Scheibenoberfläche wiederholenden identischen Strukturen mit unterschiedlichen, gezielt gegenüber dem Halbleitersubstrat veränderten Dotierungen zur Integration von mikroelektronischen Schaltungen. Zum Schutz der integrierten Schaltungen und zur Bereitstellung eines definierten Anschlussrasters folgt nach der Zerlegung der Halbleiterscheibe in einzelne Chips die Montage der integrierten Schaltungen in die Gehäuse und deren elektrischer Anschluss.

Da die Strukturen in den einzelnen Halbleiterschichten zur Ausbildung der integrierten Schaltung eine Dicke im Bereich von unter 1 µm aufweisen, entstehen bei der Strukturierung steile Stufen. Um die strukturierten Schichten zur Ausbildung der integrierten Schaltung jedoch lagegenau übereinander anordnen zu können, ist es erforderlich, diese ausgeprägte Topographie mit steilen Stufen einzuebnen. Dies gilt insbesondere dann, wenn eine Verdrahtungsebene ausgebildet werden soll. Aufgrund der begrenzten Konformität der Sputterbeschichtung ist die Dicke der Metallisierung an steilen Kanten oft sehr niedrig, wodurch in diesen Bereichen aufgrund der verringerten Leitungsquerschnitte hohe Stromdichten auftreten, die zu einem vorzeitigen Altern der Leiterbahnen führen können. Darum ist es zwingend erforderlich, Kanten bzw. Stufen auf der Halbleiteroberfläche vor der Metallisierung zu beseitigen.

Figuren 1 bis 3 zeigen eine in einem Halbleitersubstrat ausgebildete integrierte Schaltung vor der Aufbringung vor der ersten Metallstrukturebene. Die Halbleiterstruktur 1 weist dabei tiefe Gräben 2 auf, die vor allem durch die Ausbildung der Gates 3 auf der Halbleiterstruktur 1 entstehen. Solche Gates 3 bestehen im Allgemeinen aus einer Gateoxidschicht, auf der eine dotierte Polysiliziumschicht angeordnet ist. Vor der Metallisierung müssen die Gräben 2 eingeebnet werden. Zur Einebnung der Oberflächen, insbesondere unterhalb der ersten Metallstrukturebene, wird dabei fast ausschließlich die Reflow-Technik mit dotierten Silikat-Gläsern eingesetzt, wobei die Gläser mit Phosphor (PSG) oder mit Bor und Phosphor (BPSG) dotiert sind.

Die Abscheidung des dotierten Silikat-Glases erfolgt dabei im Allgemeinen in einem CVD-Prozess. Nach dem Aufbringen des dotierten Silikat-Glases wird dann ein Hochtemperaturschritt ausgeführt, so dass das dotierte Silikat-Glas aufgeschmolzen wird und so die Gräben 2 im Wesentlichen hohlraumfrei eingeebnet werden. Die zum Zerfließen des dotierten Silikat-Glases erforderliche Temperatur hängt dabei wesentlich vom Phosphorgehalt ab. Das bevorzugt verwendete BPSG hat einen Erweichungspunkt zwischen 800 und 850°C.

Um zu verhindern, dass die Dotierstoffe im Silikat-Glas beim Hochtemperaturschritt in die darunter liegende Halbleiterstruktur eindringen, wird vor dem Abscheiden der dotierten Glasschicht eine Diffusionsbarriereschicht auf der Halbleiterstruktur abgeschieden. Als Diffusionsbarriereschicht wird dabei vor allem Siliziumnitrid verwendet, das eine hervorragende Barrierewirkung gegenüber Diffusionen aller Art besitzt.

Die Siliziumnitridschichten werden dabei in CVD-Reaktoren erzeugt. Hierbei wird vor allem das LPCVD-Verfahren, bei dem eine Niederdruckabscheidung durch pyrolytische Zersetzung von SiH₂Cl₂ als Siliziumquelle und Ammoniak als Nitratquelle erfolgt, eingesetzt. Als weiteres Verfahren zur Siliziumnitriderzeugung wird auch die plasmaunterstützte CVD-Technik (PECVD) eingesetzt, bei dem SiH₄ als Siliziumquelle durch eine Hochfrequenzgasentladung angeregt und zersetzt wird, so dass es an der Halbleiteroberfläche auch bei den verwendeten niedrigen Temperaturen von 250 bis 350°C reagiert. Diese bekannten Verfahren erzeugen eine Siliziumnitridschicht 4, die sich durch eine hohe Konformität, wie in Figur 1 gezeigt ist, auszeichnet.

Diese im Wesentlichen gleichmäßige Siliziumabscheidung sowohl an den waagerechten als auch an den senkrechten Oberflächenbereichen bedeutet, dass das Tiefen-Breiten-Verhältnis y:x der Gräben 2 auf der Halbleiteroberfläche durch die Siliziumnitridschicht zunimmt. Mit der herkömmlichen Reflow-Technik mit dotierten Silikat-Gläsern, bei der im Hochtemperaturschritt eine Temperatur von unter 900°C eingesetzt wird, um eine Beschädigung der Halbleiterstruktur zu verhindern, ist es jedoch nur möglich, hohlraumfrei Gräben mit einem Tiefen-Breiten-Verhältnis von maximal 5:1 aufzufüllen. Aus diesem Grund sind mit der herkömmlichen Technik, bei der eine konforme Siliziumnitrid-Diffusionsbarriereschicht vorgesehen ist, nur Halbleiterstrukturen mit einer Breite von über 0,15 µm zuverlässig zu planarisieren.

Um auch bei Halbleiterstrukturen mit Breiten von unter 0,15 *µ*m, wie sie sich aufgrund der fortschreitenden Miniaturisierung der integrierten Schaltungen ergeben, Gräben hohlraumfrei ausfüllen zu können wird gemäß der Erfindung die Siliziumnitrid-Diffusionsbarriereschicht so auf der Halbleiterstruktur abgeschieden, dass die Abscheiderate auf waagerechten Oberflächen wesentlich größer ist, als die auf senkrechten Oberflächen. Hierdurch wird, wie in Figur 2 gezeigt ist, erreicht, dass die Schichtdicke der Siliziumnitridschicht 4 an den Seitenwänden des Grabens 2 geringer ist als auf der Boden- bzw. den Stirnflächen, so dass das Tiefen-Breiten-Verhältnis y:x kleiner ist als bei einer mit der herkömmlichen Technik abgeschiedenen Siliziumnitridschicht.

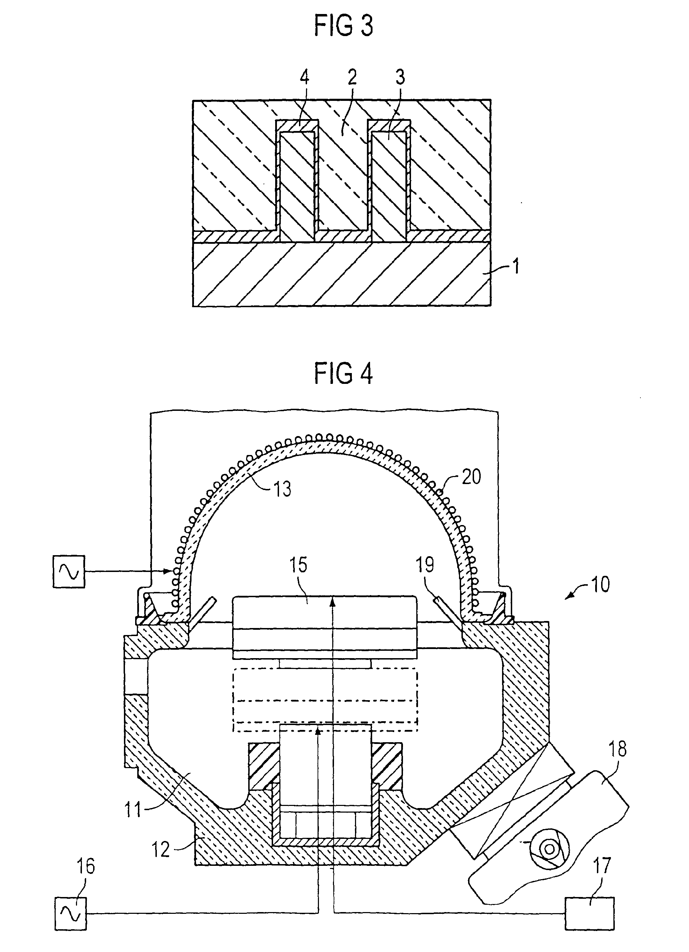

Auf der Siliziumnitridschicht 4 mit reduzierter Seitenwandstärke in den Gräben 2 lassen sich dann auch mit der herkömmlichen Reflow-Technik dotierte Silikat-Gläser aufbringen, die die Gräben 2 hohlraumfrei ausfüllen, wie in Figur 3 gezeigt ist. Es ist dann insbesondere auch möglich, bei Halbleiterstrukturen mit einer Breite unter 0,15 *µ*m eine hohlraumfreie Planarisierung der Halbleiterstruktur, insbesondere unterhalb der ersten Metallisierungsebene zu erreichen.

Um die nicht konforme Abscheidung der Siliziumnitridschicht 4 in den Gräben 2 der Halbleiterstruktur 1 zu erreichen, erfolgt die Abscheidung der Siliziumnitridschicht 4 auf der Halbleiterstrukturoberfläche mit Hilfe eines plasmaunterstützten CVD-Verfahrens, bei dem der als Nitridquelle N₂ und als Siliziumquelle SiH₄ benutzt wird. Die im Plasma enthaltenen N⁺- und SiHₓ⁺-Ionen werden dabei senkrecht zur Oberfläche der Halbleiterstruktur 1 hin beschleunigt, so dass ein Schichtwachstum primär auf solchen Flächen erfolgt, die waagerecht zur Halbleiteroberfläche verlaufen. An senkrecht orientierten Oberflächen dagegen ist das Schichtwachstum reduziert, so dass ein nicht konformes Schichtenwachstum erfolgt. Die Siliziumnitriderzeugung wird dabei vorzugsweise in einem CVD-Reaktor mit einer hohen Plasmadichte von über 1 · 10¹⁰ Ionen/cm³ ausgeführt.

Figur 4 zeigt einen CVD-Reaktor, mit dem ein solches sog. HDP-(High Density Plasma)-Verfahren durchgeführt werden kann. Solche Reaktoren werden von der Firma Novellus angeboten. Ein solcher HDP-CVD-Reaktor 10 weist, wie in Figur 4 gezeigt ist, eine Prozesskammer 11 auf, die sich aus einem wannenförmig ausgebildeten Bodenelement 12, das aus einem hochleitenden Material besteht, und einer aufgesetzten keramischen Kuppel 13 zusammensetzt. In der Prozesskammer 11 ist ein bipolarer elektrostatischer Chuck 15 im Bereich des Übergangs vom Bodenelement 12 zur Kuppel 13 angeordnet. Auf diesem Chuck 15 wird die Halbleiterstruktur 1 zum Abscheiden der Siliziumnitridschicht 4 mit Hilfe einer elektrostatischen Haltekraft festgehalten. Diese elektrostatische Kraft wird von einem Hochfrequenzgenerator 16 geliefert, der mit einer Frequenz von vorzugsweise 13,56 MHz eine Wechselspannung mit niedrigem Strom am Chuck 15 und damit am Halbleiterwafer anlegt.

Der elektrostatische Chuck 15 ist weiterhin mit einer Heizquelle 17 verbunden, um auf der Oberfläche der Halbleiterstruktur 1 die gewünschte Reaktionstemperatur zur Erzeugung des Siliziumnitrids zu erreichen. Am Bodenelement 12 ist weiterhin eine Pumpenanordnung 18 angeschlossen, mit der in der Prozesskammer 11 ein niedriger Druck von weniger als 5 mTorr erzeugt wird. Gleichzeitig werden durch seitliche Einlässe 19 im Bereich des Übergangs vom Bodenelement 12 zur Kuppel 13 die zur Herstellung des Siliziumnitrids erforderlichen Gase zugeführt. Es werden hierzu SiH₄, N₂ und H₂ eingespeist. Zur Verbesserung der Sputterwirkung kann Ar zugeführt werden.

Die Gasentladung im Reaktor wird durch induktives Einkoppeln eines Hochfrequenzfeldes mit einer Frequenz von 300 bis 400 kHz über eine Kupferspule 20, die um die Kuppel 13 gewickelt ist, erzeugt. Die Kuppelform sorgt dabei für eine sehr gleichmäßige Ionendichte im Bereich der Oberfläche der Halbleiterstruktur 1, so dass die Siliziumnitridabscheidung auch über eine große Halbleiteroberfläche erfolgen kann.

Die zum Festhalten der Halbleiterstruktur 1 auf dem Chuck 15 durch den HF-Generator 16 angelegte Wechselspannung erzeugt eine Vorspannung auf der Halbleiteroberfläche durch die die im Plasma vorliegenden Ionen, insbesondere die N⁺- und die SiHₓ⁺-Ionen zur Oberfläche hin beschleunigt werden. Hierdurch wird erreicht, dass eine nicht konforme Abscheidung der Siliziumnitridschicht 4 auf der Halbleiteroberfläche erfolgt. Bei nicht konformer Siliziumnitridabscheidung haben sich bei dem in Figur 4 gezeigten HDP-CVD-Reaktor 10 folgende Parameter als vorteilhaft erwiesen:

| Parameter | Einheit | Größe |
|---|---|---|
| | | |
| LF | Watt | 4500 |
| H₂ | sccm | 400 |
| LFdp | Watt | 1950 |
| Ar | sccm | 300 |
| N₂ | sccm | 400 |
| SiH₄ | sccm | 40 |
| SDT | sec | 29 (70nm) |

wobei LF und LFdp die Leistung vor und während der Gasentladung wiedergeben und wobei SDT der Abscheidezeit entspricht.

Die nach Erzeugung der Siliziumnitridschicht als Diffusionsbarriereschicht durchgeführte Abscheidung des dotierten Silikat-Glases kann ebenfalls mit dem in Figur 4 gezeigten Reaktor erfolgen.

Weiterhin besteht auch die Möglichkeit, statt der Siliziumnitridschicht eine andere Diffusionsbarriereschicht, z.B. Oxynitrid, zu verwenden. Entscheidend ist die nicht konforme Abscheidung der Diffusionsbarriereschicht, so dass ein vermindertes Wachstum an den senkrechten Oberflächen der Halbleiterstruktur erfolgt, wodurch ein kleineres Tiefen-Breiten-Verhältnis y:x der Vertiefungen erreicht wird.

Die in der vorstehenden Beschreibung, der Zeichnung und den Ansprüchen offenbarten Merkmale der Erfindung können sowohl einzeln als auch in beliebiger Kombination für die Verwirklichung der Erfindung in ihren verschiedenen Ausgestaltungen von Bedeutung sein.

## Patentansprüche

1. Verfahren zum Auffüllen von Vertiefungen auf der Oberfläche einer Halbleiterstruktur, insbesondere unterhalb der ersten Metallstrukturebene mit den Verfahrensschritten Erzeugen einer Diffusionsbarriereschicht auf der Oberfläche der Halbleiterstruktur mit Hilfe einer plasmaunterstützten Gasphasenabscheidung, bei der die im Plasma enthaltenen Ionen zum Aufbau der Diffusionsbarriereschicht senkrecht zur Oberfläche hin beschleunigt werden, und
Abscheiden einer Planarisierungsschicht zum Auffüllen der Vertiefungen in der Oberfläche.

2. Verfahren nach Anspruch 1, wobei die Diffusionsbarriereschicht aus Siliziumnitrid oder Oxynitrid und die Planarisierungsschicht aus dotierten Silikat-Glas, vorzugsweise BPSG, besteht.

3. Verfahren nach Anspruch 1 oder 2, wobei das Plasma bei der Erzeugung der Diffusionsbarriereschicht mindestens 1 · 10¹⁰ Ionen/cm³ enthält.

4. Halbleiterstruktur, die in einer Strukturebene, insbesondere unterhalb der ersten Metallisierungsebene, Vertiefungen enthält, wobei die Vertiefungen mit einer Diffusionsbarriereschicht, deren Schichtdicke an den senkrechten Oberflächen geringer ist als an den waagerechten Oberflächen, und einer auf der Diffusionsbarriereschicht angeordneten Planarisierungsschicht aufgefüllt sind.

5. Halbleiterstruktur nach Anspruch 4, wobei die Diffusionsbarriereschicht aus Siliziumnitrid und die Planarisierungsschicht aus dotierten Silikat-Glas, vorzugsweise BPSG, besteht.
